# DEMANDE DE BREVET EUROPEEN

(11) **EP 1 219 730 A1**
(43) Date de publication de la demande: **03.07.2002**
(21) Numéro de dépôt: 01403297.3
(22) Date de dépôt: 19.12.2001
(51) Int. Cl.: C30B 15/10, F27B 14/10

(54) **Procédé pour la protection d'un bol en matériau carboné, notamment en composite C/C, destiné à recevoir un creuset, tel qu'un creuset en silice utilisé pour le tirage de monocristaux de silicium**

(30) Priorité: 27.12.2000 FR 0017098
(71) Demandeur: SNECMA MOTEURS, 75015 Paris (FR)
(72) Inventeur: Thebault, Jacques, 33200 Bordeaux (FR); Georges, Jean-Michel, 33290 Blanquefort (FR); Coupe, Dominique, 33185 Le Haillan (FR)
(74) Mandataire: Joly, Jean-Jacques

(57) **Abrégé**

Avant de loger le creuset (5) dans le bol (1), l'on applique sur au moins une partie de la face interne du bol une strate d'interposition (6) consommable constituée essentiellement par une texture non rigide en fibres de carbone, afin de protéger le bol d'interactions physico-chimiques avec le creuset. La strate d'interposition est constituée essentiellement par une texture souple choisie parmi un tissu, un tricot, une nappe multidirectionnelle et un feutre mince. Avant mise en place de la strate dans le bol, l'on peut former sur les fibres de la texture un mince dépôt de carbone pyrolytique.

## Description

L'invention se rapporte aux bols en matériau carboné, notamment en matériau composite carbone/carbone (C/C), utilisés pour recevoir un creuset dans une installation métallurgique.

Un domaine particulier d'application de l'invention est celui des bols destinés à recevoir des creusets pour le tirage de lingots de silicium.

Un procédé bien connu de production de silicium monocristallin, destiné plus particulièrement à la fabrication de produits semi-conducteurs, consiste à faire fondre du silicium dans un réceptacle, à mettre en contact avec le bain de silicium liquide un germe de cristal ayant l'arrangement cristallin désiré, pour initier la solidification du silicium avec cet arrangement cristallin, et à tirer mécaniquement hors du creuset un lingot de silicium monocristallin ainsi obtenu. Ce procédé est connu sous l'application procédé Czochralski, ou procédé "Cz".

Le réceptacle contenant le silicium fondu est fréquemment un creuset en silice, ou quartz (SiO₂) placé dans un bol, quelquefois dénommé suscepteur. Le chauffage peut être assuré par rayonnement à partir d'un corps cylindrique en graphite, par exemple chauffé par effet Joule, qui entoure le bol.

Traditionnellement, les bols utilisés dans les procédés "Cz" sont en graphite. Les pièces en graphite utilisées comme bols sont fragiles. Elles sont réalisées souvent en plusieurs parties et ne peuvent retenir le silicium fondu en cas de rupture ou de fuite du creuset. Ce problème de sécurité devient critique avec l'augmentation de taille des lingots de silicium tirés, donc l'accroissement de la masse de silicium liquide. Par ailleurs, les bols en graphite ont généralement une faible durée de vie ainsi qu'une épaisseur importante, donc une masse et un encombrement importants.

Pour éviter ces inconvénients, il a été proposé de réaliser des bols en matériau composite C/C comprenant un renfort fibreux en fibres de carbone densifié par une matrice en carbone. Un tel matériau a en effet une tenue mécanique bien supérieure à celle du graphite et permet d'envisager la réalisation de bols de grand diamètre, par exemple atteignant, voire dépassant, 850 mm pour faire face à la demande de lingots de silicium monocristallin de plus grandes sections. En outre, l'épaisseur des bols peut être diminuée, par rapport à celle de bols en graphite, ce qui favorise la transmission de flux thermique vers le creuset et diminue la masse et l'encombrement.

La fabrication de pièces en matériau composite C/C est d'un coût relativement élevé et ce d'autant plus lorsque les pièces, comme c'est le cas de bols, ont une forme non développable et creuse. Il est important d'assurer une durée de service des bols aussi longue que possible et donc de protéger les bols contre la corrosion provoquée par réaction chimique entre le matériau constitutif du creuset et le carbone du bol.

Avec des creusets en silice, ce problème de corrosion est connu. Il se traduit par l'émission de SiO et la formation de carbure de silicium (SiC) qui, à son tour, peut réagir avec la silice du creuset, d'où une consommation progressive du composite C/C et une diminution d'épaisseur du bol qui limitent sa durée de vie en service.

Pour résoudre ce problème, il a été proposé de réaliser des bols en matériau composite C/C à double paroi : une paroi externe en matériau composite C/C à haute tenue mécanique et une paroi interne au moins en partie en matériau composite C/C constituant une garniture consommable remplaçable. Une telle solution, décrite notamment dans les demandes de brevet japonais publiées sous les n° JP 9-263 482 et JP 10-25 185, n'est pas satisfaisante du point de vue des coûts. La réalisation d'une paroi interne ou au moins d'une partie de paroi interne en matériau C/C reste longue et onéreuse, même si une moindre tenue mécanique est exigée.

On notera que la disposition d'une structure de protection en graphite ou en matériau composite C/C entre creuset et bol est connue également dans le cas de bols en graphite réalisés en plusieurs sections, comme décrit dans les documents JP 10-158089 et DE 40 07 053.

Il a aussi été proposé, notamment dans la demande de brevet japonais publiée sous le n° JP 10-059795, de munir la surface interne d'un bol en composite C/C d'un revêtement de haute pureté en carbone pyrolytique. Ce revêtement est réalisé par dépôt chimique en phase vapeur, ce qui ajoute une opération relativement longue et coûteuse au processus de fabrication du bol. En outre, un tel revêtement n'est pas exempt de corrosion chimique par le matériau du creuset ce qui, à terme, expose le matériau composite C/C à la corrosion et requiert éventuellement une nouvelle opération de dépôt chimique en phase vapeur.

Il existe donc un besoin de résoudre le problème de la protection du matériau composite C/C du bol contre la corrosion chimique par le matériau du creuset, de façon simple et peu coûteuse.

La déposante a en outre mis en évidence un autre problème lié à l'interaction non seulement chimique mais aussi physique entre le creuset et le bol.

En fonctionnement, le creuset en silice se ramollit et épouse la face interne du bol qui le contient. Lors du refroidissement, il se produit une forme de frettage du creuset dans le bol en raison des différences de variations dimensionnelles entre les matériaux du creuset et du bol. Cela engendre des contraintes dans le bol.

Avec des bols en graphite, ce problème de contraintes est résolu par une segmentation des bols en plusieurs parties. Par contre, dans le cas de bols en composite C/C, ces contraintes peuvent limiter la durée de vie ou engendrer des déformations résiduelles.

En outre, le frettage du creuset dans le bol complique l'enlèvement du creuset à la fin de chaque cycle de tirage de lingot.

De plus, les effets des phénomènes chimiques et physiques s'amplifient mutuellement.

### Objets et résumé de l'invention

L'invention a pour but de proposer une solution simple et peu coûteuse aux problèmes précités, permettant de réduire considérablement la corrosion des bols en matériau carboné, notamment en composite C/C, par le matériau du creuset, et de limiter les contraintes mécaniques engendrées dans les bols, de manière à allonger la durée de vie des bols en service.

Ce but est atteint grâce à un procédé de montage d'un creuset dans un bol en matériau carboné selon lequel, avant logement du creuset dans le bol, on applique sur au moins une partie de la face interne du bol une strate d'interposition consommable constituée essentiellement par une texture non rigide en fibres de carbone.

Une texture non rigide en fibres de carbone est par exemple un tissu, un tricot, une nappe multidirectionnelle ou un feutre mince, une telle texture ayant une souplesse lui permettant de s'adapter à la forme d'au moins une partie concave de la face interne d'un bol. Une telle texture présente en outre une macroporosité et offre une surface de contact limitée avec une surface pleine contre laquelle elle est appliquée.

L'invention est remarquable en ce que, en dépit de sa faible épaisseur et de sa porosité, une telle strate d'interposition apporte une protection efficace, comme cela sera indiqué plus en détail dans la description qui suit. En outre, une telle strate, même si elle doit être remplacée périodiquement, et présente de ce fait un caractère de produit consommable, procure une protection à coût relativement bas.

En outre, une telle strate d'interposition, du fait qu'elle présente une capacité de déformation dans son épaisseur et qu'elle n'est pas liée au matériau du bol, limite la génération de contraintes dans le bol résultant de variations dimensionnelles différentielles entre le bol et le creuset, et facilite le retrait du creuset en fin de cycle de tirage de lingot.

La strate d'interposition pourra être formée à partir d'une texture déformable capable d'épouser la forme d'une partie au moins de la face interne du bol par simple déformation de la texture, sans formation de plis.

On pourra également utiliser une strate d'interposition en une texture prédécoupée pour lui permettre d'épouser la forme d'une partie au moins de la face interne du bol.

Selon une particularité du procédé, avant mise en place de la strate d'interposition dans le bol, un revêtement mince de carbone pyrolytique peut être formé sur les fibres de la strate. Un tel revêtement mince peut être formé de manière à "fixer" les fibres pour éviter qu'elles puissent se détacher lors de l'utilisation du bol. Le revêtement mince de carbone pyrolytique pourra également être réalisé sur la strate d'interposition maintenue dans une forme voulue, de manière à "préformer" la strate d'interposition dans une forme au moins voisine de celle souhaitée, tout en ne rigidifiant pas la strate.

En pratique, l'épaisseur du revêtement en carbone pyrolytique sur les fibres n'excède pas 4 microns, de préférence est au plus égale à 2 microns. Le revêtement mince en carbone pyrolytique peut aussi éviter la diffusion d'impuretés des fibres vers le creuset.

Selon encore une autre particularité du procédé, un traitement thermique de purification est réalisé sur la strate d'interposition.

L'invention a aussi pour but de proposer une installation métallurgique, notamment pour le tirage de lingots de silicium, comprenant un bol de support en matériau composite C/C, un creuset logé dans le bol et des moyens de protection du bol interposés entre le bol et le creuset, installation dans laquelle les moyens de protection comprennent une strate d'interposition telle que définie ci-dessus.

### Brève description des dessins

L'invention sera mieux comprise à la lecture de la description faite ci-après, à titre indicatif mais non limitatif, en référence aux dessins annexés sur lesquels :
- la figure 1 est une demi-vue en coupe très schématique montrant un bol en matériau composite muni d'une strate d'interposition et utilisé comme support de creuset dans une installation de production de lingots de silicium, selon un mode de réalisation de l'invention ;
- la figure 2 illustre très schématiquement et partiellement un exemple de texture fibreuse bidimensionnelle prédécoupée pour former une strate d'interposition ; et
- la figure 3 illustre très schématiquement un outillage de mise en forme d'une strate d'interposition, selon un mode de réalisation particulier de l'invention.

### Description détaillée de modes de réalisation de l'invention

La description qui suit est faite dans le cadre de l'application de l'invention à une installation de tirage de lingots de silicium, plus particulièrement de lingots de silicium monocristallin obtenus par le procédé "Cz". L'invention est toutefois applicable à tout bol en matériau carboné pour le support de creuset, notamment dans des installations métallurgiques, et plus particulier dans le cas où le bol doit être protégé d'interactions physico-chimiques avec le creuset.

En outre, bien que l'on envisage ci-après la protection de bols en composite C/C, l'invention est applicable plus généralement aux bols en matériau carboné, c'est-à-dire aux bols réalisés en un matériau contenant au moins partiellement du carbone. Par matériau carboné, on entend en particulier des matériaux en carbone massif ou des matériaux composites dont le renfort fibreux et/ou la matrice comportent du carbone, par exemple des matériaux composites à renfort en fibres de carbone ou en fibres autres éventuellement revêtues de carbone et à matrice céramique ou à matrice mixte carbone-céramique.

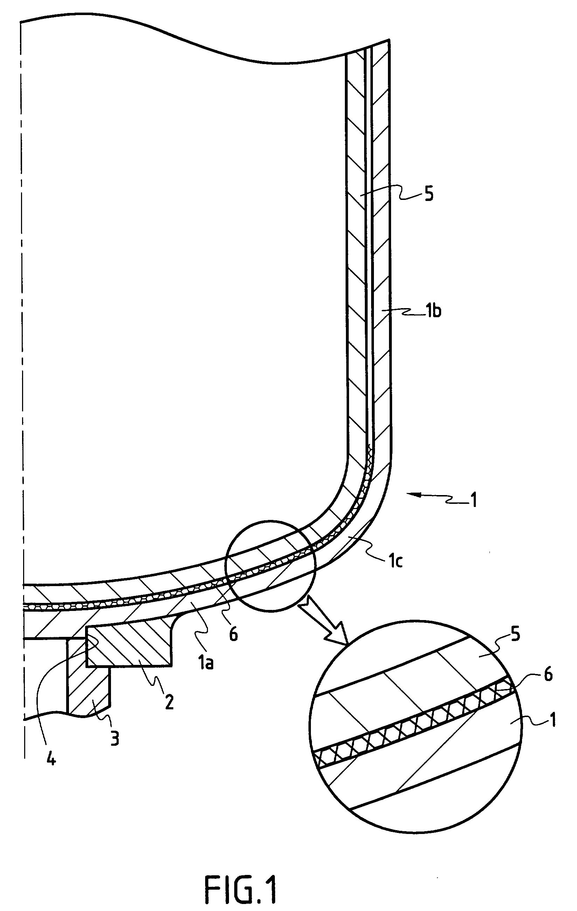

La figure 1 montre un bol en composite C/C qui supporte un creuset 5 en silice destiné à recevoir un bain de silicium. Le bol 1 repose sur un support annulaire formé par une bague 2 montée à l'extrémité d'un arbre 3 en formant avec celui-ci un décrochement 4. Le bol a une partie de fond 1a et une partie de pourtour 1b sensiblement cylindrique qui se raccorde à la partie 1a par une partie de raccordement 1c à profil arrondi. Le fond 1a du bol est usiné pour former une portée de centrage correspondant au décrochement 4 et une surface d'appui sur la bague 2.

Le bol en composite C/C est fabriqué en réalisant une préforme fibreuse de renfort, ayant une forme correspondant à celle du bol, et en densifiant la préforme par une matrice en carbone.

La préforme fibreuse peut être réalisée par bobinage filamentaire. On pourra alors laisser subsister une ouverture centrale dans le fond de la préforme, pour ne pas trop compliquer le bobinage, cette ouverture étant obturée par un fond rapporté à un stade ultérieur de la fabrication du bol.

La préforme fibreuse peut aussi être réalisée par drapage de strates bidimensionnelles sur une forme avec liaison des strates entre elles par exemple par aiguilletage. On peut utiliser des strates dans lesquelles des découpes ou fentes ont été réalisées pour qu'elles puissent épouser la forme voulue avec rapprochement des lèvres des découpes ou fentes lorsqu'elles sont drapées. On peut aussi utiliser des strates en une texture déformable capable d'épouser la forme voulue sans former de plis.

La préforme fibreuse peut être consolidée par voie liquide. A cet effet, la préforme peut être réalisée par bobinage de fils préimprégnés ou par drapage de strates préimprégnées, la préimprégnation étant effectuée avec une résine précurseur de carbone, par exemple une résine phénolique. Après polymérisation et carbonisation de la résine, le résidu carbone de la résine lie les fibres de la préforme entre elles de façon suffisante pour que la préforme puisse être manipulée sans perdre sa cohésion.

On notera que la préforme peut être réalisée par bobinage de fils secs ou drapage de strates sèches, l'imprégnation par une résine étant réalisée dans un moule contenant la préforme.

La préforme éventuellement consolidée est densifiée par une matrice de carbone pyrolytique par voie liquide : imprégnation par une résine précurseur de carbone suivie de traitement thermique de polymérisation et carbonisation, ou par voie gazeuse : infiltration chimique en phase vapeur.

La densification par infiltration chimique en phase vapeur peut être réalisée, comme cela est bien connu en soi, en plaçant la préforme consolidée dans une enceinte dans laquelle est introduite une phase gazeuse contenant un précurseur de carbone, par exemple du méthane. Les conditions de pression et de température sont choisies pour permettre une diffusion de la phase gazeuse au sein de la porosité de la préforme consolidée et une décomposition du précurseur donnant un dépôt de carbone pyrolytique sur les fibres.

Après densification, le bol obtenu est usiné et peut être soumis à un traitement final classique de purification à haute température (plus de 2000°C) sous atmosphère neutre ou réactive (par exemple halogène).

Des procédés de fabrication de bols en matériau composite C/C sont bien connus. Outre les documents déjà cités, on pourra se référer aux demandes internationales PCT/FR 00 03 275 et PCT/FR 00 03 276 de la déposante.

Conformément à l'invention, une strate d'interposition 6 essentiellement constituée par une texture mince et non rigide en fibres de carbone est interposée entre le bol 1 et le creuset 5.

Dans l'exemple illustré, la strate 6 est appliquée sur une partie de la surface interne du bol située en regard du creuset 5, à savoir les faces internes du fond 1a et de la partie de raccordement 1c. En effet, bien que la strate puisse être appliquée sur toute la face interne du bol, la présence de la strate 6 est avantageusement limitée aux zones de la surface interne du bol les plus exposées aux interactions physico-chimiques avec le creuset 5, à savoir au moins la partie de fond 1a, ou la partie de fond 1a et au moins une zone adjacente de la partie de raccordement 1c.

La texture de la strate 6 est une texture souple telle qu'un tissu, un tricot, une nappe multidirectionnelle ou un feutre mince en fibres de carbone. De préférence, l'épaisseur de la texture n'excède pas 4 mm.

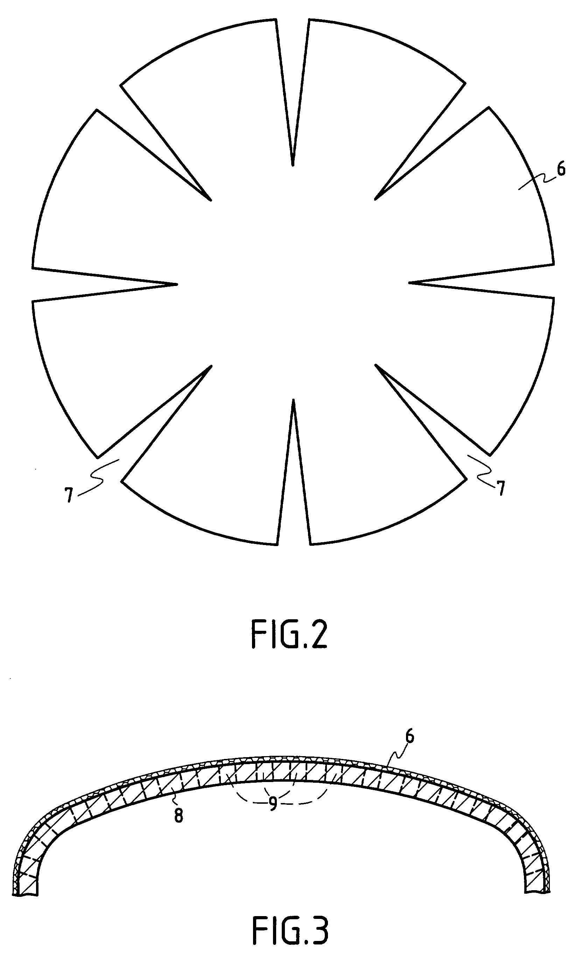

Dans le cas d'une texture souple n'ayant pas une capacité de déformation lui permettant d'épouser la forme de la face interne concave du bol sans former de plis, on pourra pratiquer des fentes ou découpes 7 dans la strate 6, par exemple comme illustré par la figure 2. Les fentes 7 s'étendent en s'élargissant à partir d'une zone centrale pleine correspondant sensiblement au centre du fond du bol. Les fentes 7 sont réalisées de manière que, lors de la mise en place de la strate d'interposition dans le bol, les lèvres des fentes se rapprochent et se joignent sans former de surépaisseurs.

En variante, on utilise une texture souple et déformable capable d'épouser la forme concave de la face interne du bol par sa déformation propre, sans former de plis et sans nécessiter la formation de fentes ou découpes. Une telle texture déformable peut être formée d'un feutre mince ou de plusieurs nappes unidirectionnelles en fils de carbone qui sont superposées avec des directions différentes et liées entre elles de façon à former des mailles élémentaires déformables.

La liaison des nappes peut être réalisée par aiguilletage léger, qui assure la cohésion de la texture, tout en ménageant une capacité de déformation suffisante. De préférence, les nappes sont liées entre elles par couture ou par tricotage au moyen d'un fil de carbone passant d'une face à l'autre de la texture.

Des textures déformables formées de deux nappes unidirectionnelles superposées avec des directions faisant entre elles un angle compris dans la plage de 45° à 90°, de préférence dans la plage de 45° à 60°, et liées entre elles par un fil tricoté sont décrites dans la demande WO 98/44182 de la déposante.

Avant mise en place dans un bol à protéger, une strate de protection, formée par une texture déformable, peut être prédéformée sur un outillage dont la surface convexe correspondant à la forme concave de la surface interne du bol que doit épouser la texture.

Un tel outillage 8 est montré sur la figure 3. Une strate 6 en texture déformable est appliquée sur l'outillage 8 en étant déformée, par exemple manuellement, avant d'être transférée dans un bol.

Un outillage du type de celui de la figure 3 peut également être utilisé pour réaliser une pré-conformation d'une strate dans la forme voulue ou dans une forme approchante, tout en lui conservant un caractère non rigide, par dépôt d'un mince revêtement de carbone pyrolytique enrobant les fibres de la texture, et ce quelle que soit la nature de la texture formant la strate.

A cet effet, la texture peut être légèrement préimprégnée, avant mise en place sur l'outillage, ou imprégnée après cette mise en place par une résine précurseur de carbone telle qu'une résine phénolique. La texture est maintenue en forme sur l'outillage pendant polymérisation et carbonisation de la résine.

En variante, la texture est mise en place à l'état sec sur l'outillage et, en étant maintenue en forme, par exemple au moyen d'un contre-outillage, est soumise à une opération de dépôt chimique en phase vapeur pour former un dépôt de carbone pyrolytique sur les fibres à partir d'une phase gazeuse contenant un précurseur gazeux du carbone, par exemple du méthane. L'outillage et le contre-outillage éventuel sont alors de préférence en graphite et présentent des passages, tels que les passages 9 montrés en traits interrompus sur la figure 3, pour favoriser l'accès de la phase gazeuse à la strate 6.

Le revêtement de carbone pyrolytique éventuellement formé sur les fibres de la strate 6 par voie liquide ou dépôt chimique en phase vapeur a une épaisseur limitée juste nécessaire pour "préformer" la strate 6, tout en lui conservant un caractère souple. L'épaisseur de dépôt peut être comprise entre 0,1 micron et 4 microns, de préférence entre 0,1 micron et 2 microns.

On notera que la formation d'un tel revêtement de carbone pyrolytique a également pour fonctions de fixer les fibres de carbone de la strate, pour éviter que des fibres ne se détachent de la strate et viennent polluer le milieu environnant, et d'éviter la diffusion d'impuretés des fibres vers le creuset.

On notera encore que le même dépôt mince de carbone pyrolytique par voie liquide ou par infiltration chimique en phase vapeur peut être formé sur les fibres de la texture avant une éventuelle mise en forme sur un outillage ou son insertion directement dans le bol, la texture conservant la souplesse nécessaire pour épouser la forme voulue.

Par ailleurs, avant sa mise en place dans le bol, la strate d'interposition pourra être soumise à un traitement de purification en étant portée à une température supérieure à 2000°C, par exemple de 2200°C à 2700°C, sous atmosphère neutre ou sous atmosphère d'halogène.

En dépit de sa faible épaisseur et de sa porosité, la strate d'interposition utilisée conformément à l'invention protège efficacement le bol des interactions physico-chimiques avec le creuset. En effet, elle agit non seulement comme strate d'isolement entre le bol et le creuset et couche de protection consommable à la place du bol, mais aussi :
- elle limite la surface de contact avec le creuset à quelques fibres de carbone, en raison de sa texture aérée, et limite donc la quantité de gaz SiO engendré par réaction entre SiO₂ et C ;
- elle offre une surface réactive importante (surface des fibres de la texture) au gaz SiO produit, de sorte que celui-ci, diffusant à travers la porosité de la strate, réagit avec le carbone des fibres de celle-ci et est pratiquement totalement consommé avant d'atteindre le bol ;
- elle n'est pas liée au bol et, par sa souplesse, son frottement réduit et sa capacité de déformation en épaisseur, permet un déplacement relatif avec glissement éventuel entre le creuset et le bol, ce qui permet, d'une part, d'absorber des variations dimensionnelles différentielles et de réduire fortement les contraintes mécaniques induites sur le bol par ces variations et, d'autre part, de faciliter le retrait du creuset après un cycle de tirage de lingots.

### Exemple 1

Une texture fibreuse est réalisée par tricotage d'un fil de carbone 6K du commerce, c'est-à-dire un fil formé de 6000 filaments en carbone.

On réalise un tricotage aéré en contexture interlock, la masse surfacique du tricot étant d'environ 300 g/m², et l'épaisseur du tricot étant environ égale à 1,5 mm.

La texture est découpée selon un disque de 700 mm de diamètre et une bordure est réalisée avec le fil de carbone pour éviter l'effilochage de la texture.

La strate ainsi obtenue est placée au fond d'un bol en composite C/C de diamètre interne 22 pouces (environ 560 mm) pour garnir le fond du bol et la zone adjacente de la partie de raccordement, avant mise en place d'un creuset contenant du silicium.

Après un cycle de tirage de lingot de silicium, le creuset et la strate d'interposition sont ôtés du bol, éventuellement en morceaux, et sont rebutés. Grâce à l'emploi de la strate d'interposition, le fond du bol présente très peu de traces d'attaque chimique (consommation de la paroi du bol) ou de traces de sollicitations mécaniques (telles que déformations résiduelles ou fissures). Le bol est réutilisé après mise en place d'une nouvelle strate d'interposition.

L'utilisation d'une strate d'interposition conforme à l'invention apporte donc une protection efficace à un coût relativement réduit.

### Exemple 2

Une texture fibreuse est réalisée par tissage (armure toile) de fils de carbone 1K du commerce. Le tissu obtenu est introduit dans un four d'infiltration chimique en phase vapeur pour former sur les fibres un mince dépôt de carbone pyrolytique d'épaisseur environ égale à 0,5 micron. On utilise de façon classique une phase gazeuse contenant du méthane en tant que précurseur de carbone.

Le tissu obtenu, qui reste souple, est découpé au jet d'eau pour obtenir une forme analogue à celle de la figure 2.

La strate d'interposition conformable obtenue est placée entre le fond d'un bol en matériau composite C/C et un creuset.

Après un cycle de tirage de lingot en silicium, et retrait du creuset et du résidu de strate d'interposition, on constate que le fond du bol présente très peu de traces d'attaque chimique ou de sollicitations mécaniques.

## Revendications

1. Procédé pour le montage d'un creuset dans un bol en matériau carboné, **caractérisé en ce que**, avant de loger le creuset dans le bol, l'on applique sur au moins une partie de la face interne du bol une strate d'interposition consommable constituée essentiellement par une texture non rigide en fibres de carbone, afin de protéger le bol d'interactions physico-chimiques avec le creuset.

2. Procédé selon la revendication 1, **caractérisé en ce que** l'on utilise une strate d'interposition constituée essentiellement par une texture souple choisie parmi un tissu, un tricot, une nappe multidirectionnelle et un feutre mince.

3. Procédé selon l'une quelconque des revendications 1 à 2, **caractérisé en ce que**, avant sa mise en place dans le bol, la strate d'interposition est mise dans une forme au moins voisine de celle de ladite partie de face interne du bol.

4. Procédé selon l'une quelconque des revendications 1 à 3, **caractérisé en ce que**, avant mise en place de la strate dans le bol, l'on forme sur les fibres de la texture un mince dépôt de carbone pyrolytique.

5. Procédé selon la revendication 4, **caractérisé en ce que** le dépôt de carbone pyrolytique a une épaisseur qui n'excède pas 4 microns.

6. Procédé selon la revendication 5, **caractérisé en ce que** dépôt de carbone pyrolytique a une épaisseur comprise entre 0,1 micron et 2 microns.

7. Procédé selon l'une quelconque des revendications 1 à 6, **caractérisé en ce que** l'on prédécoupe la strate d'interposition pour lui permettre d'épouser la forme de ladite partie de face interne du bol.

8. Procédé selon l'une quelconque des revendications 1 à 6, **caractérisé en ce que** l'on utilise une strate d'interposition en une texture déformable capable d'épouser la forme de ladite partie de face interne du bol par déformation de la texture sans former de plis.

9. Procédé selon l'une quelconque des revendications 1 à 8, **caractérisé en ce que** l'on soumet la strate d'interposition à un traitement thermique de purification.

10. Installation métallurgique comprenant un bol en matériau carboné, un creuset logé dans le bol et une garniture de protection du bol interposée entre au moins une partie de la face interne du bol et le creuset, **caractérisée en ce que** la garniture de protection est formée par une strate d'interposition non rigide consommable constituée essentiellement par une texture en fibres de carbone.

11. Installation selon la revendication 10, **caractérisée en ce que** la strate d'interposition est constituée essentiellement par une texture choisie parmi un tissu, un tricot, une nappe multidirectionnelle et un feutre mince.

12. Installation selon l'une quelconque des revendications 10 et 11, **caractérisée en ce que** l'épaisseur de la strate d'interposition n'excède pas 4 mm.

13. Installation selon l'une quelconque des revendications 10 à 12, **caractérisée en ce que** la strate d'interposition comprend un mince dépôt de carbone pyrolytique sur les fibres de la texture.

14. Installation selon la revendication 13, **caractérisée en ce que** l'épaisseur du dépôt de carbone pyrolytique n'excède pas 4 microns.

15. Installation selon la revendication 14, **caractérisée en ce que** l'épaisseur du dépôt de carbone pyrolytique est comprise entre 0,1 micron et 2 microns.

16. Installation selon l'une quelconque des revendications 10 à 15, **caractérisée en ce que** le bol est en matériau composite carbone/carbone.

17. Installation selon l'une quelconque des revendications 10 à 16, pour le tirage de lingots de silicium, **caractérisée en ce que** la strate d'interposition est disposée entre une partie au moins de la face interne du bol et un creuset en silice destiné à recevoir du silicium.
